# EUROPÄISCHE PATENTANMELDUNG

(11) **EP 4 576 441 A1**
(43) Veröffentlichungstag der Anmeldung: **25.06.2025**
(21) Anmeldenummer: 23217586.9
(22) Anmeldetag: 18.12.2023
(51) Int. Cl.: H01R 12/55

(54) **ELEKTRISCHE STECKVERBINDERANORDNUNG**

(71) Anmelder: Hilti Aktiengesellschaft, 9494 Schaan (LI)
(72) Erfinder: Tussing, Torsten, 86836 Obermeitingen (DE); Langsdorf, Saskia, 86916 Kaufering (DE); Mahler, Thomas, 18299 Laage (DE)
(74) Vertreter: Hilti Aktiengesellschaft Corporate Intellectual Property

(57) **Zusammenfassung**

Elektrischer Platinen-Steckverbinder mit wenigstens einem elektrischen Kontaktelement, das zumindest abschnittsweise von einem Steckergehäuse des Platinen-Steckverbinders umgeben ist, wobei der Platinen-Steckverbinder wenigstens ein Verbindungselement zum elektrischen und mechanischen Verbinden des Platinen-Steckverbinders mit einer Leistungsplatine aufweist, wobei das Verbindungselement als Kühlelement zum Abführen von Wärme aus dem Platinen-Steckverbinder ausgebildet ist.

## Beschreibung

Die vorliegende Erfindung betrifft einen elektrischen Platinen-Steckverbinder mit wenigstens einem elektrischen Kontaktelement, das zumindest abschnittsweise von einem Steckergehäuse des Platinen-Steckverbinders umgeben ist. Der Platinen-Steckverbinder weist wenigstens ein Verbindungselement zum elektrischen und mechanischen Verbinden des Platinen-Steckverbinders mit einer Leistungsplatine auf.

Solche Platinen-Steckverbinder sind aus der EP 2 610 974 B1 bekannt. EP 2 893 596 B1 zeigt eine elektrische Verbinder-Anordnung mit einem ersten und einem zweiten Eingriffsabschnitt, wobei wenigstens ein erstes Lüftungsloch in dem ersten Eingriffsabschnitt ausgebildet ist, um Wärme aus dem ersten Eingriffsabschnitt abzuleiten, und wenigstens ein zweites Lüftungsloch in dem zweiten Eingriffsabschnitt ausgebildet ist, um Wärme aus dem zweiten Eingriffsabschnitt abzuleiten.

Es ist Aufgabe der vorliegenden Erfindung einen elektrischen Platinen-Steckverbinder anzugeben, der die Grundlage für eine Übertragung hoher Ströme schafft. Es ist ebenfalls Aufgabe der vorliegenden Erfindung eine Platinen-Anordnung mit einer einen Kühlkörper aufweisenden Leistungsplatine und mit einem elektrischen Platinen-Steckverbinder anzugeben.

Bezüglich des Platinen-Steckverbinder wird die Aufgabe dadurch gelöst, dass das Verbindungselement als Kühlelement zum Abführen von Wärme aus dem Platinen-Steckverbinder ausgebildet ist. Bezüglich der Platinen-Anordnung wird die Aufgabe dadurch gelöst, dass das Verbindungselement des Platinen-Steckverbinder dem Kühlkörper benachbart angeordnet ist, so dass ein den Kühlkörper passierender Kühlluftstrom auch das als Kühlelement vorgesehene Verbindungselement erfasst. Vorteilhafterweise kann durch das Verbindungselement oder mehrere Verbindungselemente ein Kühlbereich gebildet werden, der zwischen der elektrischen Anbindung an eine Leistungsplatine (die beispielsweise über Befestigungsösen realisiert sein kann) und dem elektrischen Kontaktierungsbereich (definiert durch ein oder mehrere Kontaktelemente) befindlich ist.

Die Platinen-Anordnung ist vorzugsweise Teil einer Werkzeugmaschine, die durch Akkumulatoren mit elektrischer Energie versorgt wird.

Die Erfindung schließt die Erkenntnis ein, dass Akkumulatoren - und dementsprechend auch durch Akkumulatoren betriebene Werkzeugmaschinen - immer leistungsfähiger werden. Durch die hohe elektrische Leistung wird auch die Stromstärke (bzw. Ströme), die beispielsweise mittels eines Platinen-Steckverbinders übertragen müssen, immer größer.

Allerdings ist die Stromtragfähigkeit solcher Steckverbinder typischerweise limitiert. Sind die zu übertragende Ströme zu hoch, kann der Steckverbinder aufgrund von Überhitzung ausfallen. In typischen Steckverbindern werden kleine Metallsegmente mit Federkraft gegen eine Steckfahne gepresst, um den elektrischen Übergangswiderstand möglichst gering zu halten. Wird der Steckverbinder zu hoch bestromt, erwärmt er sich zu sehr. Durch Erwärmung der Metallteile lässt die Federkraft nach, der Übergangswiderstand und damit die Erwärmung nehmen noch weiter zu. Dies ist ein sich selbst verstärkender Prozess der zum Ausfall des Steckverbinders führen kann.

Dadurch, dass das Verbindungselement des Platinen-Steckverbinder als Kühlelement zum Abführen von Wärme aus dem Platinen-Steckverbinder ausgebildet ist, kann eine Erwärmung des Steckverbinders reduziert und somit die Stromtragfähigkeit erhöht werden.

In einer besonders bevorzugten Ausgestaltung weist das Verbindungselement eine vorzugsweise plane Kühloberfläche mit einer in Einsteckrichtung des Steckergehäuses definierten Breite und einer senkrecht zur Einsteckrichtung des Steckergehäuses definierten Länge auf. Es hat sich als vorteilhaft herausgestellt, wenn die Länge wenigstens doppelt so groß ist wie die Breite. Die Länge des Verbindungselements außerhalb des Steckergehäuses beträgt vorzugsweise wenigstens 2 Zentimeter. In einer besonders bevorzugten Ausgestaltung ist das elektrische Kontaktelement als Steckfahne ausgebildet.

Es hat sich als vorteilhaft herausgestellt, wenn das Verbindungselement zumindest abschnittsweise außerhalb des Steckergehäuses befindlich ist. Somit kann eine räumliche Trennung von Kühlen (ein oder mehrere Kühloberflächen) und elektrischer Kontaktierung (ein oder mehrere elektrische Kontaktelemente) erreicht werden.

In einer weiteren bevorzugten Ausgestaltung sind das elektrische Kontaktelement und das Verbindungselement miteinander einstückig ausgebildet, wobei der Anteil des Verbindungselements vorzugsweise vollständig außerhalb des Steckergehäuses befindlich ist und/oder der Anteil des Verbindungselements vollständig innerhalb eines Volumens des Steckergehäuses befindlich ist. Es hat sich als vorteilhaft herausgestellt, wenn das Kontaktelement und/oder das Verbindungselement aus Metall bestehen. Es hat sich weiterhin als vorteilhaft herausgestellt, wenn das elektrische Kontaktelement mit dem Verbindungselement elektrisch und/oder thermisch gekoppelt ist, beispielsweise durch eine Ausbildung als gemeinsames Blechteil.

In einer besonders bevorzugten Ausgestaltung ist am Verbindungselement, auf einer dem Kontaktelement abgewandten Seite, eine Befestigungsöse ausgebildet. Über eine solche Öse kann das Verbindungselement vorteilhafterweise mit einer Leistungsplatine verschraubt werden. Alternativ oder zusätzlich kann die Anbindung des Verbindungselements an die Leistungsplatine über eine Lötfahne oder dergleichen realisiert sein.

In einer weiteren bevorzugten Ausgestaltung weist der Platinen-Steckverbinder mehrere Verbindungselemente, vorzugsweise genau drei Verbindungselemente auf. Es hat sich als vorteilhaft herausgestellt, wenn der Platinen-Steckverbinder mehrere Kontaktelemente, vorzugsweise genau sechs Kontaktelemente aufweist. Es hat sich weiterhin als vorteilhaft herausgestellt, wenn pro Verbindungselement je zwei elektrische Kontaktelemente vorgesehen sind. Besonders bevorzugt sind zwei elektrischen Kontaktelemente einstückig mit dem Verbindungselement ausgebildet.

In einer weiteren bevorzugten Ausgestaltung ist das Kontaktelement und/oder das Verbindungselement abschnittsweise in das Steckergehäuses eingebettet, beispielweise mittels Kunststoffspritzguss. Es hat sich als vorteilhaft herausgestellt, wenn das Steckergehäuse aus Kunststoff besteht oder Kunststoff aufweist.

Im Folgenden werden bevorzugte Ausgestaltungen der erfindungsgemäßen Platinen-Anordnung beschrieben.

Es hat sich als vorteilhaft herausgestellt, wenn der Kühlkörper der Leistungsplatine eine Kühlrippe aufweist, die sich im Wesentlichen flächenparallel zum Verbindungselement, vorzugsweise zu einer am Verbindungselement ausgebildeten Kühloberfläche, erstreckt. In einer weiteren bevorzugten Ausgestaltung fluchtet das Verbindungselement, insbesondere bezogen auf eine Erstreckung seiner Breite, mit der Kühlrippe des Kühlkörpers. Es hat sich als vorteilhaft herausgestellt, wenn mehrere Kühlrippen und mehrere Verbindungselemente vorgesehen sind, wobei vorzugsweise je ein Verbindungselemente mit je einer Kühlrippe fluchtet.

In einer weiteren bevorzugten Ausgestaltung weist die Platinen-Anordnung ein vorzugsweise tunnelförmig ausgebildetes Luftführungselement auf. Es hat sich als vorteilhaft herausgestellt, wenn das Luftführungselement den Kühlkörper und/oder das Verbindungselement teilweise einhaust, vorzugsweise an drei Seiten. Mittels des Verbindungselements kann ein Kühlluftstrom gezielt entlang dem Kühlkörper und/oder dem Verbindungselement geführt und so die Wärmeabfuhr verbessert werden.

Es hat sich ebenfalls als vorteilhaft herausgestellt, wenn der Kühlkörper zwangsbelüftet ist. Dies kann durch einen Lüfter, beispielsweise einen ohnehin in einer Werkzeugmaschine vorhandenen Lüfter, geschehen.

In einer besonders bevorzugten Ausgestaltung ist das Verbindungselement, bezogen auf den Kühlluftstrom, dem Kühlkörper nachgeschaltet.

In einer weiteren bevorzugten Ausgestaltung ragt das Verbindungselement durch das Luftführungselement hindurch. Dadurch kann ein gekühlter Bereich der Verbindungselemente vom elektrischen Kontaktierungsbereich der Kontaktelemente getrennt werden.

Es hat sich als vorteilhaft herausgestellt, wenn die Platinen-Anordnung einen zu dem Platinen-Steckverbinder komplementär ausgebildeten Kabel-Steckverbinder aufweist, wobei der Platinen-Steckverbinder und der Kabel-Steckverbinder in zusammengesteckten Zustand zur Umgebung hin gekapselt sind.

Weitere Vorteile ergeben sich aus der folgenden Figurenbeschreibung. In den Figuren sind besonders bevorzugte Ausführungsbeispiele der vorliegenden Erfindung dargestellt. Die Figuren, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

In der Figur sind gleiche und gleichartige Komponenten mit gleichen Bezugszeichen beziffert. Es zeigt:
- Figur 1: ein bevorzugtes Ausführungsbeispiel eines Platinen-Steckverbinders;
- Figur 2: eine teiltransparente Darstellung des Platinen-Steckverbinders der Figur 1;
- Figur 3: ein bevorzugtes Ausführungsbeispiel einer Platinen-Anordnung in teilweise geschnittener Darstellung;
- Figur 4: die Platinen-Anordnung der Figur 3 ohne Schnitt des Luftführungselements.

### Ausführungsbeispiele:

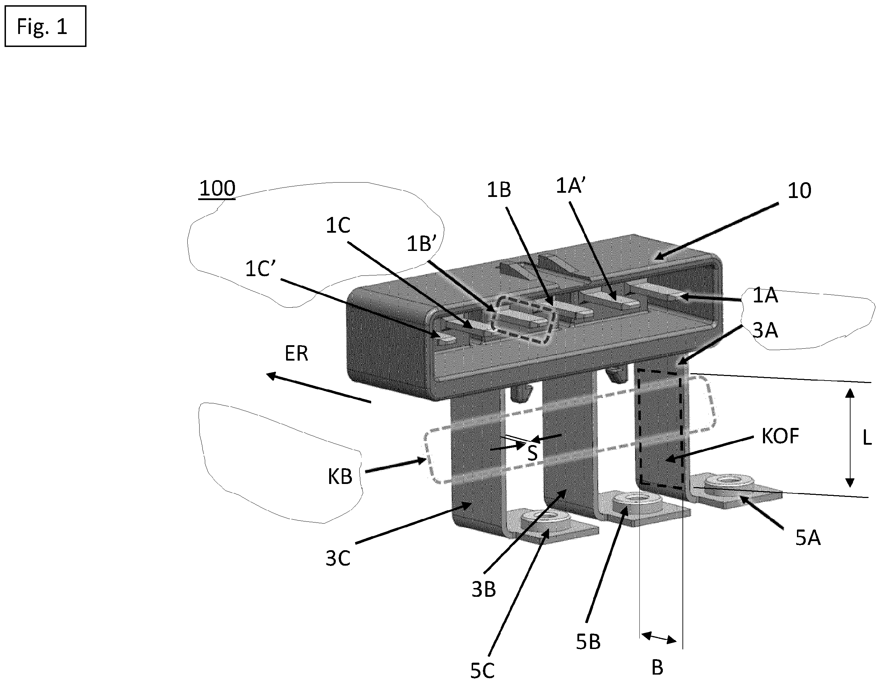

Ein bevorzugtes Ausführungsbeispiel eines erfindungsgemäßen elektrischen Platinen-Steckverbinders 100 ist in Figur 1 gezeigt.

Der elektrische Platinen-Steckverbinder 100 enthält sechs elektrische Kontaktelemente 1A, 1A', 1B, 1 B', 1C, 1C'. Des Weiteren enthält der Platinen-Steckverbinder 100 ein Steckergehäuse 10.

Wie in Figur 1 dargestellt, werden die sechs Kontaktelemente 1A, 1A`, 1B, 1B`, 1C, 1C' von dem Steckergehäuse 10 umgeben. Das Steckergehäuse 10 schützt die sechs Kontaktelemente 1A, 1A', 1B, 1B', 1C, 1C' unter anderem vor mechanischen Beschädigungen. Gemäß einer alternativen Ausgestaltungform können auch mehr oder weniger als sechs Kontaktelemente vorgesehen sein.

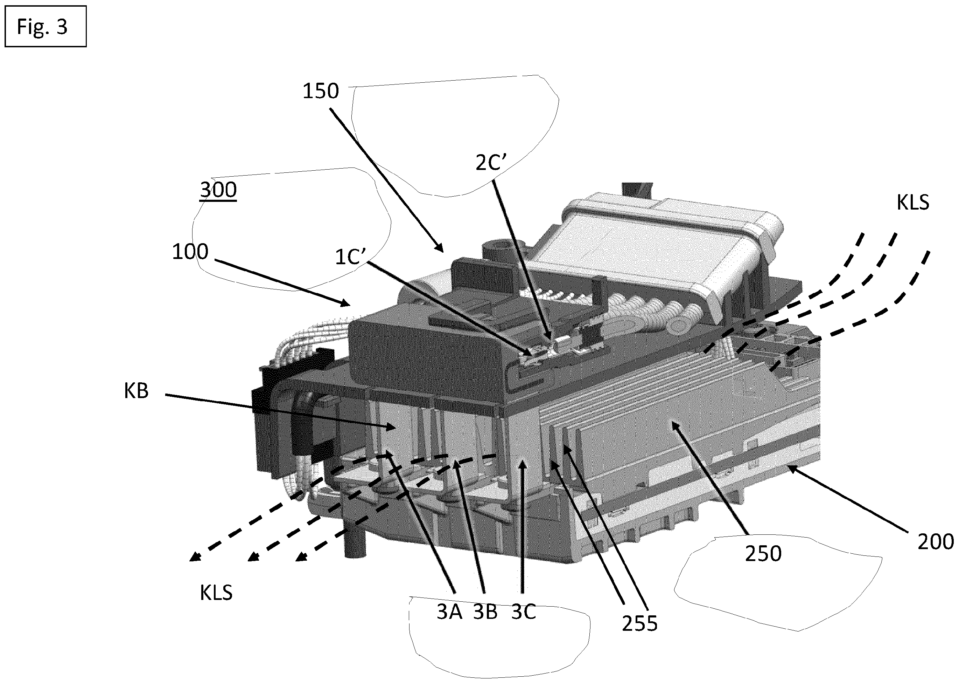

Der Platinen-Steckverbinder 100 weist weiterhin drei Verbindungselemente 3A, 3B, 3C zum elektrischen und mechanischen Verbinden des Platinen-Steckverbinders 100 mit einer Leistungsplatine 200 (vgl. Figur 3) auf. Zu diesem Zweck weisen die Verbindungselemente 3A, 3B, 3C jeweils eine Befestigungsöse 5A, 5B, 5C auf. Die Verbindungselemente 3A, 3B, 3C befinden sich außerhalb des Steckergehäuses 10. Entsprechend einer alternativen Ausgestaltungform können auch mehr oder weniger als drei Verbindungselemente enthalten sein.

Wie der Figur 1 entnommen werden kann, sind die Verbindungselemente 3A, 3B, 3C jeweils als Kühlelement zum Abführen von Wärme aus dem Platinen-Steckverbinder 100 ausgebildet. Dabei weist jedes der Verbindungselemente 3A, 3B, 3C - hier beispielhaft eingezeichnet am ersten Verbindungselement 3A - eine plane Kühloberfläche KOF mit einer in Einsteckrichtung ER des Steckergehäuses 10 definierten Breite B und einer senkrecht zur Einsteckrichtung ER des Steckergehäuses 10 definierten Länge L auf. Die Länge L ist beispielhaft wenigstens doppelt so groß wie die Breite B. Des Weiteren weist jedes der Verbindungselemente 3A, 3B, 3C eine Wandstärke S von 2 mm auf. Die Wandstärke S kann generell zwischen 1,0 bis 2,5 mm betragen.

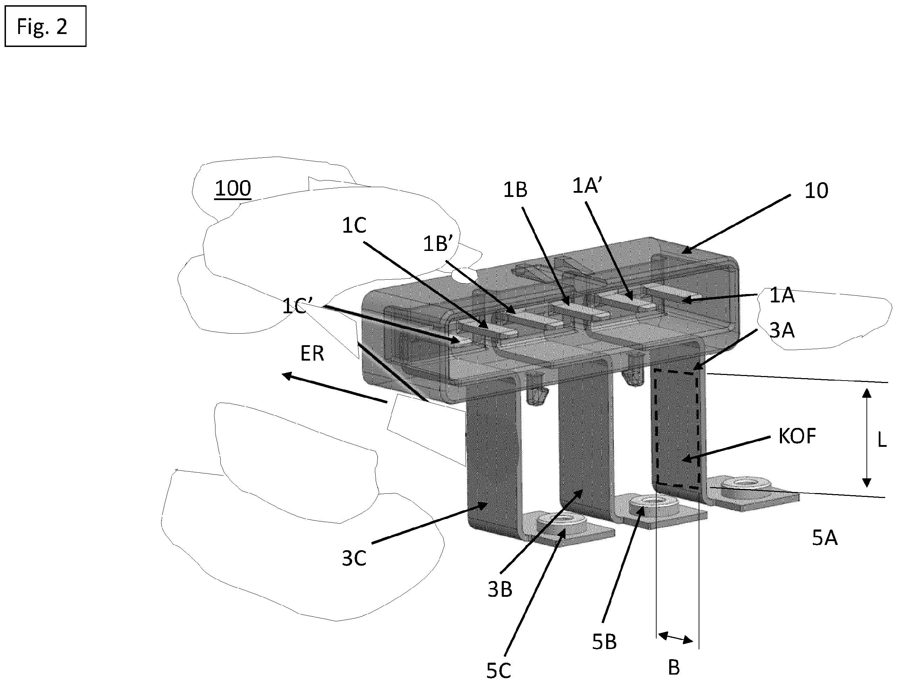

Die jeweiligen Kühloberflächen KOF der Verbindungselemente 3A, 3B, 3C definieren gemeinsam einen Kühlbereich KB, über welchen Wärme aus dem Platinen-Steckverbinder 100 abgeführt werden kann. In Figur 1 und 2 sind die Verbindungselemente 3A, 3B, 3C als gerade Blechstege dargestellt. Gemäß alternativer Ausführungsformen kann jedes der Verbindungselemente 3A, 3B, 3C auch wellenförmig oder zick-zack-förmig ausgestaltet sein. Darüber hinaus können die Verbindungselemente 3A, 3B, 3C in einer Seitenansicht auch ungleichförmig ausgestaltet sein. Das Verhältnis zwischen der Länge eines Verbindungselements 3A, 3B, 3C zu einer Breite eines Verbindungselements 3A, 3B, 3C kann dabei wenigstens 2 zu 1 betragen.

Generell ist jedes Verbindungselement 3A, 3B, 3C derartig ausgestaltet, dass jeweils eine elektrische Stromstärke von 40 A bis 250 A übertragbar ist.

In dem in Figur 1 dargestellten Ausführungsbeispiel sind die elektrischen Kontaktelemente 1A, 1A', 1B, 1B', 1C, 1C' als Steckfahnen ausgebildet, d.h. sie weisen einen im Wesentlichen rechteckigen Querschnitt auf.

Figur 2 zeigt eine teiltransparente Darstellung des Platinen-Steckverbinders 100 der Figur 1. Wie in Figur 2 gezeigt, sind für jedes der drei Verbindungselemente 3A, 3B, 3C je zwei elektrische Kontaktelemente 1A, 1A'; 1B, 1B'; 1C, 1C' vorgesehen. Die ersten beiden elektrischen Kontaktelemente 1A, 1A' sind einstückig mit dem ersten Verbindungselement 3A ausgebildet, die zweiten beiden elektrischen Kontaktelemente 1B, 1B' sind einstückig mit dem zweiten Verbindungselement 3B ausgebildet, und die dritten beiden elektrischen Kontaktelemente 1C, 1C' sind einstückig mit dem dritten Verbindungselement 3C ausgebildet.

Sowohl die als Steckfahnen ausgebildeten elektrischen Kontaktelemente 1A, 1A', 1B, 1B', 1C, 1C' als auch die flächig ausgebildeten Verbindungselemente 3A, 3B, 3C sind jeweils abschnittsweise in dem Steckergehäuses 10 eingebettet.

Ein bevorzugtes Ausführungsbeispiel einer Platinen-Anordnung in teilweise geschnittener Darstellung ist in Figur 3 dargestellt. Die Platinen-Anordnung 300 ist ausgestattet mit einer einen Kühlkörper 250 aufweisenden Leistungsplatine 200 und mit einem elektrischen Platinen-Steckverbinder 100, der mit bereits mit Bezug auf Figur 1 und Figur 2 beschrieben wurde.

Wie der Figur 3 entnommen werden kann, ist der Platinen-Steckverbinder 100 mit der Leistungsplatine 200 schraubverbunden. Die drei Verbindungselemente 3A, 3B, 3C des Platinen-Steckverbinders 100 sind neben dem Kühlkörper 250 angeordnet, so dass ein den Kühlkörper 250 passierender Kühlluftstrom KLS auch das als Kühlelement ausgebildeten Verbindungselement 3A, 3B, 3C erfasst. Wie in Figur 3 gezeigt, weist der Kühlkörper 250 mehrere Kühlrippen 255 auf, die sich im Wesentlichen flächenparallel zu den flächig ausgebildeten Verbindungselementen 3A, 3B, 3C erstrecken.

Im vorliegend dargestellten Ausführungsbeispiel wird der Kühlkörper 250 durch einen hier nicht dargestellten Lüfter einer Akkubetriebenen Werkzeugmaschine zwangsbelüftet, sodass der Kühlluftstrom KLS in Pfeilrichtung bewirkt wird. Die drei Verbindungselemente 3A, 3B, 3C - und somit der gemeinsame Kühlbereich KB (vgl. Figur 1) - sind bezogen auf den Kühlluftstrom KLS dem Kühlkörper 250 nachgeschaltet. Der gemeinsame Kühlbereich KB ist sandwichartig zwischen der elektrischen Anbindung an die Leistungsplatine 200 (die über die bereits beschriebenen Befestigungsösen realisiert ist) und dem elektrischen Kontaktierungsbereich (definiert durch die elektrischen Kontaktelemente 1A, 1A', 1B, 1B', 1C, 1C') befindlich.

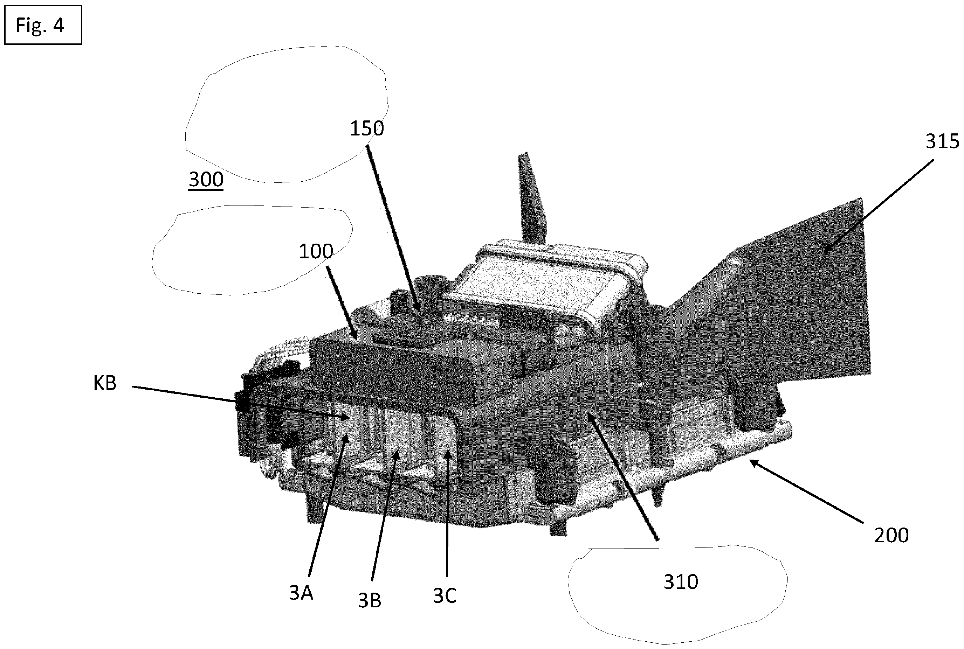

Figur 4 zeigt schließlich die Ausstattung der Platinen-Anordnung 300 mit einem tunnelförmig ausgebildeten Luftführungselement 310. Das Luftführungselement 310 weist einen tunnelförmigen Schaft 315 auf, über den der Kühlluftstrom gezielt zum Kühlkörper 250 (vgl. die Schnittdarstellung der Figur 3) geführt werden kann. Im Übrigen ist gut zu erkennen, dass die drei Verbindungselemente 3A, 3B, 3C durch das Luftführungselement 310, das lediglich unterhalb des Steckergehäuses 10 teilweise geschlitzt ist, hindurchragen. Somit ist der Kühlbereich KB durch äußere Einflüsse (wie beispielsweise Schmutz in Form von Staub) geschützt.

Die Platinen-Anordnung 300 verfügt über einen zu dem Platinen-Steckverbinder 100 komplementär ausgebildeten Kabel-Steckverbinder 150, wobei der Platinen-Steckverbinder 100 und der Kabel-Steckverbinder 150 in zusammengesteckten Zustand (dieser ist in Figur 4 auch dargestellt) zur Umgebung hin gekapselt sind. Über den Kabel-Steckverbinder 150 erfolgt der Anschluss der Leistungsplatine 200 an einen hier nicht dargestellten Akkumulator einer Werkzeugmaschine. In Figur 3 ist beispielhaft ein zum Kontaktelement 1C' komplementäres Kontaktelement 2C' gezeigt, über das eine elektrische Verbindung realisiert ist.

### Bezugszeichenliste

- 1A bis 1C`: Kontaktelement
- 2C': komplementäres Kontaktelement
- 3A bis 3C: Verbindungselement
- 5A bis 5C: Befestigungsöse
- 10: Steckergehäuse
- 100: Platinen-Steckverbinder
- 150: Kabel-Steckverbinder
- 200: Leistungsplatine
- 250: Kühlkörper
- 255: Kühlrippe
- 300: Platinen-Anordnung
- 310: Luftführungselement
- 315: tunnelförmiger Schaft
- B: Breite der Kühloberfläche
- ER: Einsteckrichtung des Steckergehäuses
- KB: Kühlbereich
- KOF: Kühloberfläche
- KLS: Kühlluftstrom
- L: Länge der Kühloberfläche
- S: Wandstärke eines Verbindungselements

## Patentansprüche

1. Elektrischer Platinen-Steckverbinder (100) mit wenigstens einem elektrischen Kontaktelement (1A), das zumindest abschnittsweise von einem Steckergehäuse (10) des Platinen-Steckverbinders (100) umgeben ist, wobei der Platinen-Steckverbinder (100) wenigstens ein Verbindungselement (3A) zum elektrischen und mechanischen Verbinden des Platinen-Steckverbinders (100) mit einer Leistungsplatine (200) aufweist,
**dadurch gekennzeichnet, dass** das Verbindungselement (3) als Kühlelement zum Abführen von Wärme aus dem Platinen-Steckverbinder (100) ausgebildet ist.

2. Platinen-Steckverbinder (100) nach Anspruch 1,
**dadurch gekennzeichnet, dass** das Verbindungselement (3A) eine vorzugsweise plane Kühloberfläche (KOF) mit einer in Einsteckrichtung (ER) des Steckergehäuses (10) definierten Breite (B) und einer senkrecht zur Einsteckrichtung (ER) des Steckergehäuses (10) definierten Länge (L) aufweist, wobei die Länge (L) wenigstens doppelt so groß ist wie die Breite (B).

3. Platinen-Steckverbinder (100) nach Anspruch 1 oder 2,
**dadurch gekennzeichnet, dass** das elektrische Kontaktelement (1A) als Steckfahne ausgebildet ist.

4. Platinen-Steckverbinder (100) nach einem der vorangehenden Ansprüche,
**dadurch gekennzeichnet, dass** das Verbindungselement (3A) zumindest abschnittsweise außerhalb des Steckergehäuses (10) befindlich ist.

5. Platinen-Steckverbinder (100) nach einem der vorangehenden Ansprüche,
**dadurch gekennzeichnet, dass** das elektrische Kontaktelement (1A) und das Verbindungselement (3A) miteinander einstückig mitausgebildet sind, wobei diese vorzugsweise aus Metall bestehen.

6. Platinen-Steckverbinder (100) nach einem der vorangehenden Ansprüche,
**dadurch gekennzeichnet, dass** am Verbindungselement (3A), auf einer dem Kontaktelement (1A) abgewandten Seite, eine Befestigungsöse (5) ausgebildet ist.

7. Platinen-Steckverbinder (100) nach einem der vorangehenden Ansprüche,
**dadurch gekennzeichnet, dass** mehrere Verbindungselemente (3A, 3B, 3C) und pro Verbindungselement je zwei elektrische Kontaktelemente (1A, 1A'; 1B, 1B'; 1C, 1C') vorgesehen sind.

8. Platinen-Anordnung (300) mit einer einen Kühlkörper (250) aufweisenden Leistungsplatine (200) und mit einem elektrischen Platinen-Steckverbinder (100) nach einem der vorangehenden Ansprüche, wobei der Platinen-Steckverbinder (100) mit der Leistungsplatine (200) verbunden ist, und das Verbindungselement (3A) des Platinen-Steckverbinders (100) dem Kühlkörper (250) benachbart angeordnet ist, so dass ein den Kühlkörper (250) passierender Kühlluftstrom (KLS) auch das als Kühlelement ausgebildete Verbindungselement (3A) erfasst.

9. Platinen-Anordnung (300) nach Anspruch 8,
**dadurch gekennzeichnet, dass** der Kühlkörper (250) eine Kühlrippe (255) aufweist, die sich im Wesentlichen flächenparallel zum Verbindungselement (3A) erstreckt.

10. Platinen-Anordnung (300) nach Anspruch 8 oder 9,
**dadurch gekennzeichnet, dass** die Platinen-Anordnung (300) ein vorzugsweise tunnelförmig ausgebildetes Luftführungselement (310) aufweist.

11. Platinen-Anordnung (300) nach einem der Ansprüche 8 bis 10,
**dadurch gekennzeichnet, dass** der der Kühlkörper (250) zwangsbelüftet ist und das Verbindungselement (3A), bezogen auf den Kühlluftstrom (KLS), vorzugsweise dem Kühlkörper (250) nachgeschaltet ist.

12. Platinen-Anordnung (300) nach einem der Ansprüche 8 bis 11,
**dadurch gekennzeichnet, dass** das Verbindungselement (3A) durch das Luftführungselement (310) hindurchragt.

13. Platinen-Anordnung (300) nach einem der Ansprüche 8 bis 12,
**dadurch gekennzeichnet, dass** die Platinen-Anordnung (300) einen zu dem Platinen-Steckverbinder (100) komplementär ausgebildeten Kabel-Steckverbinder (150) aufweist, wobei der Platinen-Steckverbinder (100) und der Kabel-Steckverbinder (150) in zusammengesteckten Zustand zur Umgebung hin gekapselt sind.

14. Akkuwerkzeug mit einem Gehäuse, das eine Platinen-Anordnung (300) nach einem der vorangehenden Ansprüche umfasst.
